# EUROPÄISCHE PATENTSCHRIFT

(11) **EP 1 719 044 B1**
(45) Veröffentlichungstag und Bekanntmachung des Hinweises auf die Patenterteilung: **31.03.2010**
(21) Anmeldenummer: 05715226.6
(22) Anmeldetag: 29.01.2005
(51) Int. Cl.: G06F 1/20, H05K 7/20, H02B 1/56

(54) **GER TEANORDNUNG**
ASSEMBLY OF DEVICES
ENSEMBLE DE DISPOSITIFS

(30) Priorität: 17.02.2004 DE 102004008460
(43) Veröffentlichungstag der Anmeldung: 08.11.2006
(73) Patentinhaber: Rittal GmbH & Co. KG, 35745 Herborn (DE)
(72) Erfinder: NICOLAI, Michael, 35466 Rabenau (DE); DÖRRICH, Martin, 35756 Mittenaar (DE)
(74) Vertreter: Fleck, Hermann-Josef
(86) Internationale Anmeldenummer: PCT/EP2005/000895
(87) Internationale Veröffentlichungsnummer: WO 2005/081091

(56) Entgegenhaltungen:
- DE-C1- 10 210 658
- DE-U1- 8 807 768
- US-A- 3 749 981
- US-A- 6 109 053

## Beschreibung

Die Erfindung betrifft eine Geräteanordnung mit wenigstens einem Schaltschrank und einem Kühlgerät, wobei der Schaltschrank einen geschlossenen Innenraum aufweist, in dem elektrische Einbauten unterbringbar sind, wobei das Kühlgerät im Bereich einer vertikal zur Frontseite stehenden Seitenfläche des Schaltschrankes angebaut ist und sich zumindest über einen Teil der Schaltschrankhöhe erstreckt und mit dem Innenraum über wenigstens einen Lufteinlaß und wenigstens eine Ausblasöffnung in räumlicher Verbindung steht, und wobei das Kühlgerät einen Aufnahmeraum mit wenigstens einem darin untergebrachten Wärmetauscher aufweist.

Eine derartige Geräteanordnung ist aus dem Firmenkatalog Rittal Handbuch 30 Seite 448 oder aus dem Dokument DE 102 10 658 C1 bekannt. Dabei weist das Kühlgerät ein geschlossenes Gehäuse auf, das anstelle einer Tür oder einer Seitenwand an den Schaltschrank angebaut werden kann. In dem Gehäuse ist ein Wärmetauscher untergebracht, der über eine Luftführung in räumlicher Verbindung mit dem Innenraum des Schaltschrankes steht. Die Luft wird aus dem Dachbereich des Schaltschrankes abgesaugt, im Wärmetauscher gekühlt und im Bodenbereich wieder zugeführt. Aus Platzgründen werden die Innenräume von Schaltschränken zunehmend kompakter bestückt. Dadurch entsteht eine größere abzuführende Verlustwärme. Das Kühlgerät muss bei einer solchen Aufrüstung dann ausgetauscht werden, gegen ein Gerät höherer Kühlleistung.

Es ist Aufgabe der Erfindung, eine Geräteanordnung der eingangs erwähnten Art zu schaffen, die an sich verändernde Kühlanforderungen leicht angepasst werden kann.

Diese Aufgabe wird dadurch gelöst, dass der Aufnahmeraum des Kühlgerätes zumindest bereichsweise in zwei oder mehrere vertikal übereinander angeordnete Teil-Aufnahmeräume unterteilt ist, und dass in wenigstens einem der Teil-Aufnahmeräume ein Kühlmodul untergebracht ist.

Der Aufnahmeraum des Kühlgerätes ist so ausgebildet und unterteilt, dass er modular mit einem oder mehreren Wärmetauschereinheiten ausgerüstet werden kann. Damit läßt sich das Kühlgerät an wachsende Anforderungen indiviudell anpassen. Der Aufnahmeraum des Klimagerätes ist erfindungsgemäß vertikal unterteilt. Damit können bei Bedarf Zonen gebildet werden, mit denen analog übereinander gelagerte Kühlbereiche im Innenraum des Schaltschrankes geschaffen werden können. Auf diese Weise kann verhindert werden, dass durch aufsteigende Wärme Bereiche mit hohem thermischen Niveau entstehen.

Eine gezielte Luftführung kann auf einfache Weise dann erreicht werden, wenn vorgesehen ist, dass die Teil-Aufnahmeräume auf ihrer dem Schaltschrank zugekehrten Seite mittels einer Abdeckung verschlossen sind, dass die Abdeckung den Lufteinlaß und die Ausblasöffnung bildet, und dass ein auf der Außenseite der Abdeckung angeordnetes Dichtelement im Bereich zwischen dem Lufteinlass und der Ausblasöffnung einen Luftkurzschluss verhindert.

Wenn vorgesehen ist, dass das Kühlmodul als getrennte Baueinheiten eine Wärmetauscher-Einheit und wenigstens eine Lüftereinheit aufweist, dann kann das Kühlmodul leicht gehandhabt werden. Dies ist vor allem bei beengten Platzverhältnissen von Vorteil. Beispielsweise in Rechenzentren wird zwischen Schaltschrankreihen nur ein 80 cm breiter Gang gebildet. Mit der vorliegenden Erfindungsausgestaltung kann das Kühlmodul aus seinen Baugruppen bequem im Teil-Aufnahmeraum des Kühlgerätes zusammengebaut werden.

Ein stabiler Aufbau ergibt sich für das Kühlgerät dann, wenn vorgesehen ist, dass das Kühlgerät ein aus horizontalen und vertikalen Rahmenprofilen zusammengesetztes Rahmengestell aufweist, wobei die Rahmenprofile in den Ecken des Rahmengestelles miteinander verbunden sind, dass zur Abteilung der Teil-Aufnahmeräume an dem Rahmengestell horizontal Fachböden befestigt sind und dass das/die Kühlmodule auf den Fachböden abstellbar sind. Wenn dabei zusätzlich vorgesehen ist, dass das Kühlmodul oder die Teil-Baueinheiten (gemäß Anspruch 3) eine Baubreite aufweisen, die kleiner ist als das lichte Öffnungsmaß zwischen den zwei frontseitigen vertikalen Rahmenprofilen des Rahmengestelles, dann können das Kühlmodul von der Gerätefrontseite und/oder Rückseite eingebaut werden. Dies ist insbesondere dann von Vorteil, wenn bei beengten Platzverhältnissen seitlich kein oder ein nicht ausreichender Zugang zum Kühlgerät vorhanden ist.

Eine Bauvariante für die Geräteanordnung kann beispielsweise so gestaltet sein, dass das Kühlgerät an seiner dem Schaltschrank abgewandten Seite mittels eines Wandelementes gedichtet abgeschlossen ist.

Es ist jedoch auch denkbar, dass das Kühlgerät zwischen zwei Schaltschränken eingebaut ist, und dass die Teil-Aufnahmeräume wahlweise mit dem Innenraum eines oder beider Schaltschränke in luftleitende Verbindung bringbar sind. Auf diese Weise können auch mit einem Kühlgerät gleichzeitig zwei Schaltschränke klimatisiert werden.

Eine mögliche Erfindungsvariante ist dergestalt, dass das Kühlgerät eine Vor- und eine Rücklaufleitung aufweist, über die ein Kühlmedium förderbar ist, und dass die Wärmetauscher-Einheiten an die Vor- und-Rücklaufleitung anschließbar sind. Die Vor- und die Rücklaufleitung können beispielsweise an eine externe Rückkühlanlage angeschlossen sein. Die Versorgung der Wärmetauscher-Einheiten mit Kälteleistung ist damit auf einfache Weise gelöst.

Wenn dabei zusätzlich vorgesehen ist, dass die Vor- und Rücklaufleitung tropffrei füg- und trennbare Schnellkupplungen aufweist, mittels denen die Kühlmodule angeschlossen sind, dann ist für den Anschluss der Kühlmodule nicht zwingend Fachpersonal notwendig.

Eine bevorzugte Anwendung der Erfindung ist dadurch gegeben, dass die elektrischen Einbauten als Servereinheiten ausgebildet sind, die in Richtung der Schaltschranktiefe verlaufende Kühlkanalstrukturen aufweisen, und dass die Ausblasöffnung der Kühlkanalstruktur im Bereich der Frontseite des Schaltschrankes und der Lufteinlaß im Bereich der Rückseite des Schaltschrankes zugeordnet ist.

Die Erfindung wird im folgenden anhand eines in den Zeichnungen dargestellten Ausführungsbeispieles näher erläutert. Es zeigen:
- Fig. 1: in perspektivischer Seitendarstellung ein Kühlgerät und
- Fig. 2: eine Geräteanordnung bestehend aus zwei Schaltschränken und dem in Fig. 1 dargestellen Klimagerät.

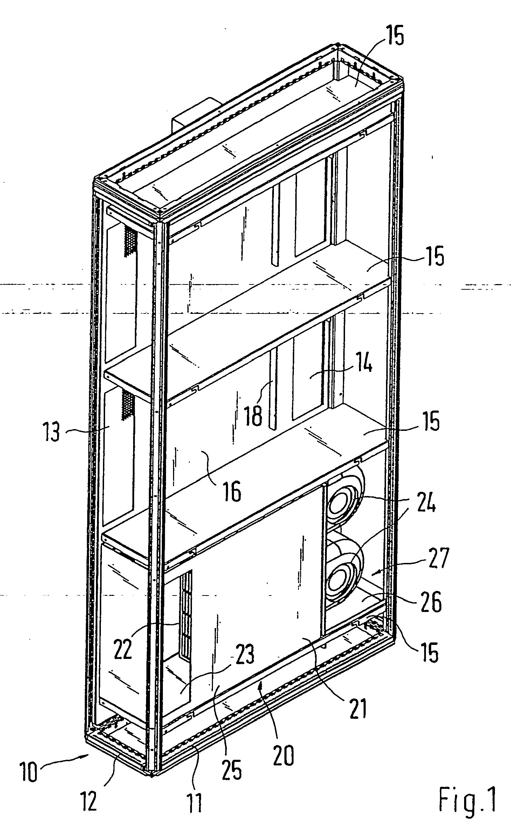

Die Fig. 1 zeigt ein Kühlgerät 10 mit einem Rahmengestell. Dieses ist aus zwölf Rahmenprofilen 11, 12, 13 zusammengesetzt. Die horizontalen Rahmenprofile 11, 12 bilden einen Boden- und einen Deckrahmen, in deren Eckbereichen die vier querschnittsgleichen vertikalen Rahmenprofile 13 eingeschweißt sind. Der von dem Rahmengestell umgebene Aufnahmeraum ist mittels horizontaler Fachböden 15 in drei Teil-Aufnahmeräume unterteilt. Die Teil-Aufnahmeräume können auf den Rahmengestell-Breitseiten mittels seitlicher Abdeckungen 16 beidseitig überdeckt werden. Die Abdeckungen 16 weisen je einen Lufteinlaß 14 und eine Ausblasöffnung 13 auf. Die vorder- und rückseitigen Schmalseiten sowie die Dachseite des Rahmengestelles 15 sind mit geeigneten Blenden überdeckt. Die Fachböden 15 sind an den vertikalen Rahmenprofilen 13 befestigt und dienen zur Aufnahme je eines Kühlmodules 20. Dabei ist jedes Kühlmodul 20 aus zwei Baueinheiten, einer Wärmetauscher-Einheit 21 und einer Lüftereinheit 24 zusammengesetzt.

Die Wärmetauscher-Einheit 21 weist ein Wärmetauscher-Gehäuse 25 auf, in das ein Luft-Wasser-Wärmetauscher 22 eingesetzt ist. Das Wärmetauscher-Gehäuse 25 besitzt zwei Austassöffnungen 23, die in Flucht zu der Ausblasöffnung 13 der Abdeckungen 16 angeordnet werden können.

Die Lüftereinheit 24 besitzt ein Lüfter-Gehäuse 26, das zwei Lüfter 24 aufnimmt. Das Lüfter-Gehäuse 26 steht über seine offenen Seiten 27 in luftleitender Verbindung mit den Lufteinlässen 14 der Abdeckungen 16.

Zur Montage des Kühlmoduls 20 wird die Wärmetauscher-Einheit 21 durch die offene Frontseite des Rahmengestelles zwischen den beiden vertikalen Rahmenprofilen 13 auf dem Fachboden 15 in den zugehörigen Teil-Aufnahmeraum eingeschoben bis das Wärmetauscher-Gehäuse 25 an einem Anschlag 18 der Abdeckungen 16 die Einsetzbewegung begrenzt. In gleicher Weise wird von der Rückseite des Rahmengestelles her die Lüftereinheit 24 auf dem als Gleitführung dienenden Fachboden 15 in den Teil-Aufnahmeraum eingeschoben. Der Anschlag 18 begrenzt wieder die Einsetzbewegung.

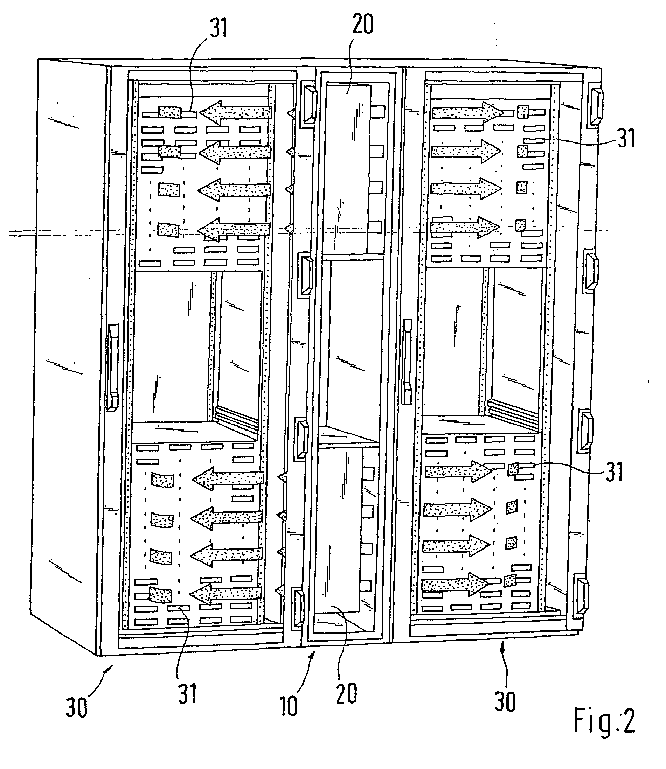

Das in Fig. 1 dargestellte Kühlgerät 10 kann in einer Geräteanordnung, wie sie beispielsweise in Fig. 2 gezeigt ist, verbaut werden. Dabei ist das Kühlgerät 10 zwischen zwei Schaltschränken 30 eingebaut. Die Schaltschränke 30 sind in ihrer Bauweise konventionell aufgebaut und weisen ein mit Wandelementen und einer frontseitigen Tür verkleidetes Rahmengestell auf. An den einander zugewandten Schaltschrankseiten ersetzt das Kühlgerät 10 das Wandelement.

Die Schaltschränke 30 sind, wie dies die Zeichnung erkennen lässt, mit je zwei Server-Einheiten (elektrische Einbauten 31) bestückt. Dabei ist je eine Server-Einheit im Dach- bzw. Bodenbereich des Schaltschrankes 30 angeordnet. Zwischen den beiden Server-Einheiten ist ein Leerraum, der bei Bedarf zur Komplettierung des Innenraums des Schaltschrankes 30 mit einer dritten Server-Einheit bestückt werden kann. Entsprechend der Belegung des Schaltschrankes 30 nimmt das Kühlgerät 10 zwei Kühlmodule 20 auf. Jedes der Kühlmodule 20 steht über die Lufteinlässe 14 und die Ausblasöffnungen 23 in räumlicher Verbindung mit den Innenräumen beider Schaltschränke 30. Mittels der Lüfter-Einheiten 24 kann Luft im Bereich der Rückseite der Schaltschränke 30 über eine Kanalstruktur der Server-Einheiten in Richtung der Schaltschrank-Tiefe gefördert werden. Diese Luft wird in dem Wärmetauscher 22 der Wärmetauscher-Einheit 21 gekühlt und dann wieder im Bereich der Frontseite der Schaltschränke 30 über die Ausblasöffnungen 13 der Kanalstruktur zugeleitet. Wenn zu einem späteren Zeitpunkt die Schaltschränke 30 mit einer dritten Server-Einheit aufgerüstet werden sollen, kann auch auf einfache Weise ein drittes Kühlmodul 20 im Kühlgerät 10 nachgerüstet werden.

Falls nur in einem Schaltschrank 30 eine Server-Einheit nachgerüstet werden soll, wird zum anderen Schaltschrank 30 hin eine Abdeckung 1 6 eingebaut, die keinen Luftdurchtritt ermöglicht. Auf diese Weise lassen sich auch sämtliche Teil-Aufnahmeräume jeweils auf die individuellen Einbau-Gegebenheiten im Schaltschrank 30 anpassen.

Das Kühlgerät lässt sich auch alleine mit nur einem Schaltschrank 30 verbauen. Die dem Schaltschrank 30 abgekehrte Kühlgeräte-Seite ist dann mit einer Seitenwand abgeschlossen.

## Patentansprüche

1. Geräteanordnung mit wenigstens einem Schaltschrank und einem Kühlgerät, wobei der Schaltschrank einen geschlossenen Innenraum aufweist, in dem elektrische Einbauten unterbringbar sind, wobei das Kühlgerät im Bereich einer vertikal zur Frontseite stehenden Seitenfläche des Schaltschrankes angebaut ist und sich zumindest über einen Teil der Schaltschrankhöhe erstreckt und mit dem Innenraum über wenigstens einen Lufteinlaß und wenigstens eine Ausblasöffnung in räumlicher Verbindung steht, und wobei das Kühlgerät einen Aufnahmeraum mit wenigstens einem darin untergebrachten Wärmetauscher aufweist,
**dadurch gekennzeichnet,**
**dass** der Aufnahmeraum des Kühlgerätes (10) zumindest bereichsweise in zwei oder mehrere vertikal übereinander angeordnete Teil-Aufnahmeräume unterteilt ist, und
**dass** in wenigstens einem der Teil-Aufnahmeräume ein Kühlmodul (20) untergebracht ist.

2. Geräteanordnung nach Anspruch 1,
**dadurch gekennzeichnet,**
**dass** die Teil-Aufnahmeräume auf ihrer dem Schaltschrank (30) zugekehrten Seite mittels einer Abdeckung (16) verschlossen sind,
**dass** die Abdeckung (16) den Lufteinlass (14) und die Ausblasöffnung (13) bildet; und
**dass** ein auf der Außenseite der Abdeckung (16) angeordnetes Dichtelement (17) im Bereich zwischen dem Lufteinlass (14) und der Ausblasöffnung (13) einen Luftkurzschluss verhindert.

3. Geräteanordnung nach Anspruch 1 oder 2,
**dadurch gekennzeichnet,**
**dass** das Kühlmodul (20) als getrennte Baueinheiten eine Wärmetauscher-Einheit (22) und wenigstens eine Lüftereinheit (24) aufweist.

4. Geräteanordnung nach einem der Ansprüche 1 bis 3,
**dadurch gekennzeichnet,**
**dass** das Kühlgerät (10) ein aus horizontalen und vertikalen Rahmenprofilen (11, 12, 13) zusammengesetztes Rahmengestell aufweist, wobei die Rahmenprofile (11, 12, 13) in den Ecken des Rahmengestelles miteinander verbunden sind,
**dass** zur Abteilung der Teil-Aufnahmeräume an dem Rahmengestell horizontal Fachböden (15) befestigt sind und
**dass** die Kühlmodule (20) auf den Fachböden (15) abstellbar sind.

5. Geräteanordnung nach Anspruch 4,
**dadurch gekennzeichnet,**
**dass** die Kühlmodule (20) oder die Teil-Baueinheiten (gemäß Anspruch 3) eine Baubreite aufweisen, die kleiner ist als das lichte Öffnungsmaß zwischen den zwei frontseitigen vertikalen Rahmenprofilen (13) des Rahmengestelles.

6. Geräteanordnung nach einem der Ansprüche 1 bis 5,
**dadurch gekennzeichnet,**
**dass** das Kühlgerät (10) an seiner dem Schaltschrank (30) abgewandten Seite mittels eines Wandelementes gedichtet abgeschlossen ist.

7. Geräteanordnung nach einem der Ansprüche 1 bis 6,
**dadurch gekennzeichnet,**
**dass** das Kühlgerät (20) zwischen zwei Schaltschränken (30) eingebaut ist, und
**dass** die Teil-Aufnahmeräume wahlweise mit dem Innenraum eines oder beider Schaltschränke (30) in luftleitende Verbindung bringbar sind.

8. Geräteanordnung nach einem der Ansprüche 1 bis 7,
**dadurch gekennzeichnet,**
**dass** wenigsten eines der Kühlmodule (20) über Lüfteinlässe (14) und Ausblasöffnungen (13) mit beiden Innenräumen der Schaltschränke (30) in räumlicher Verbindung stehen.

9. Geräteanordnung nach einem der Ansprüche 1 bis 8,
**dadurch gekennzeichnet,**
**dass** das Kühlgerät (20) eine Vor- und eine Rücklaufleitung aufweist, über die ein Kühlmedium förderbar ist, und
**dass** die Kühlmodule (20) an die Vor- und Rücklaufleitung anschließbar sind.

10. Geräteanordnung nach Anspruch 9,
**dadurch gekennzeichnet,**
**dass** die Vor- und Rücklaufleitung tropffrei füg- und trennbare Schnellkupplungen aufweist, mittels denen die Kühlmodule (20) angeschlossen sind.

11. Geräteanordnung nach einem der Ansprüche 1 bis 10,
**dadurch gekennzeichnet,**
**dass** die elektrischen Einbauten (31) als Servereinheiten ausgebildet sind, die in Richtung der Schaltschranktiefe verlaufende Kühlkanalstrukturen aufweisen, und
**dass** die Ausblasöffnung (13) der Kühlkanalstruktur im Bereich der Frontseite des Schaltschrankes (30) und der Lufteinlass (14) im Bereich der Rückseite des Schaltschrankes (30) zugeordnet ist.

## Claims

1. Assembly of devices comprising at least one switchgear cabinet and a cooling device, the switchgear cabinet having a closed interior, in which built-in electrical components can be housed, the cooling device being attached in the vicinity of a side surface of the switchgear cabinet that is vertical with respect to the front face and extending at least over part of the height of the switchgear cabinet and having a spatial connection with the interior via at least one air inlet and at least one vent opening, and the cooling device comprising a receiving chamber that houses at least one heat exchanger, **characterized in that** at least sections of the receiving chamber of the cooling device (10) are divided into two or more receiving sub-chambers that are arranged vertically above one another, and **in that** a cooling module (20) is housed in at least one of the receiving sub-chambers.

2. Assembly of devices according to Claim 1, **characterized in that** the receiving sub-chambers are sealed on their side which faces the switchgear cabinet (30) by means of a cover (16), **in that** the cover (16) forms the air inlet (14) and the vent opening (13), and **in that** a sealing element (17) arranged on the outside of the cover (16) in the area between the air inlet (14) and the vent opening (13) prevents the air being short-circuited.

3. Assembly of devices according to Claim 1 or 2, **characterized in that** the cooling module (20) has a heat exchanger unit (22) and at least one fan unit (24) as separate structural units.

4. Assembly of devices according to one of Claims 1 to 3, **characterized in that** the cooling device (10) has a rack constructed from horizontal and vertical frame profiles (11, 12, 13), the frame profiles (11, 12, 13) being joined together in the corners of the rack, **in that** horizontal compartment floors (15) are fixed to the rack in order to divide the receiving sub-chambers into compartments, and **in that** the cooling modules (20) can be placed on the compartment floors (15).

5. Assembly of devices according to Claim 4, **characterized in that** the cooling modules (20) or the structural sub-units (according to Claim 3) have an overall width which is less than the clearance size of the opening between the two front vertical frame profiles (13) of the rack.

6. Assembly of devices according to one of Claims 1 to 5, **characterized in that** the cooling device (10) is sealed closed on its side which faces away from the switchgear cabinet (30) by means of a wall element.

7. Assembly of devices according to one of Claims 1 to 6, **characterized in that** the cooling device (20) is fitted between two switchgear cabinets (30), and **in that** the receiving sub-chambers can optionally be connected to conduct air to the interior of one or both switchgear cabinets (30).

8. Assembly of devices according to one of Claims 1 to 7, **characterized in that** at least one of the cooling modules (20) is spatially connected to both interiors of the switchgear cabinets (30) via air inlets (14) and vent openings (13).

9. Assembly of devices according to one of Claims 1 to 8, **characterized in that** the cooling device (20) has a feed and return line via which a cooling medium can be pumped, and **in that** the cooling modules (20) can be connected to the feed and return line.

10. Assembly of devices according to Claim 9, **characterized in that** the feed and return line has drip-free, quick-connect and quick-release couplings by means of which the cooling modules (20) are connected.

11. Assembly of devices according to one of Claims 1 to 10, **characterized in that** the built-in electrical components (31) are designed in the form of server units which have cooling channel structures in the direction of the depth of the switchgear cabinet, and **in that** the vent opening (13) is associated with the cooling channel structure at the front of the switchgear cabinet (30) and the air inlet (14) at the rear of the switchgear cabinet (30).

## Revendications

1. Ensemble de dispositifs comprenant au moins une armoire de distribution et un appareil de refroidissement, dans lequel l'armoire de distribution présente un espace intérieur fermé dans lequel des composants électriques peuvent être installés, dans lequel l'appareil de refroidissement est monté dans la région d'une face latérale de l'armoire de distribution perpendiculaire à la face frontale et s'étend au moins sur une partie de la hauteur de l'armoire de distribution et est en communication spatiale avec l'espace intérieur par au moins une entrée d'air et au moins une ouverture d'expulsion, et dans lequel l'appareil de refroidissement présente une chambre de réception comportant au moins un échangeur de chaleur installé dans celle-ci, **caractérisé en ce que** l'espace intérieur de l'appareil de refroidissement (10) est divisé au moins localement en deux ou plus de deux chambres de réception partielles disposées verticalement l'une au-dessus de l'autre, et **en ce qu'**un module de refroidissement (20) est installé dans au moins une des chambres de réception partielles.

2. Ensemble de dispositifs selon la revendication 1, **caractérisé en ce que** les chambres de réception partielles sont fermées sur leur côté tourné vers l'armoire de distribution (30) au moyen d'un couvercle (16), **en ce que** le couvercle (16) forme l'entrée d'air (14) et l'ouverture d'expulsion (13), et **en ce qu'**un élément d'étanchéité (17) disposé sur le côté extérieur du couvercle (16) empêche un court-circuit de l'air dans la région entre l'entrée d'air (14) et l'ouverture d'expulsion (13).

3. Ensemble de dispositifs selon la revendication 1 ou 2, **caractérisé en ce que** le module de refroidissement (20) présente une unité d'échangeur de chaleur (22) et au moins une unité de ventilateur (24) sous forme de modules séparés.

4. Ensemble de dispositifs selon l'une quelconque des revendications 1 à 3, **caractérisé en ce que** l'appareil de refroidissement (10) présente une charpente de cadre composée de profilés de cadre horizontaux et verticaux (11, 12, 13), les profilés de cadre (11, 12, 13) étant assemblés les uns aux autres dans les angles de la charpente de cadre, **en ce que** des plateaux horizontaux (15) sont fixés à la charpente de cadre pour diviser les chambres de réception partielles, et **en ce que** les modules de refroidissement (20) peuvent être déposés sur les plateaux (15).

5. Ensemble de dispositifs selon la revendication 4, **caractérisé en ce que** les modules de refroidissement (20) ou les modules partiels (selon la revendication 3) présentent une largeur de construction, qui est plus petite que la largeur d'ouverture libre entre les deux profilés de cadre verticaux frontaux (13) de la charpente de cadre.

6. Ensemble de dispositifs selon l'une quelconque des revendications 1 à 5, **caractérisé en ce que** l'appareil de refroidissement (10) est fermé de façon étanche sur son côté orienté à l'opposé de l'armoire de distribution (30) au moyen d'un élément de paroi.

7. Ensemble de dispositifs selon l'une quelconque des revendications 1 à 6, **caractérisé en ce que** l'appareil de refroidissement (20) est monté entre deux armoires de distribution (30), et **en ce que** les chambres de réception partielles sont mises en communication d'air au choix avec l'espace intérieur d'une ou des deux armoires de distribution (30).

8. Ensemble de dispositifs selon l'une quelconque des revendications 1 à 7, **caractérisé en ce qu'**au moins un des modules de refroidissement (20) est en communication spatiale avec les deux espaces intérieurs des armoires de distribution (30) par des entrées d'air (14) et des ouvertures d'expulsion (13).

9. Ensemble de dispositifs selon l'une quelconque des revendications 1 à 8, **caractérisé en ce que** l'appareil de refroidissement (20) présente une conduite d'arrivée et de retour, permettant d'amener un fluide de refroidissement, et **en ce que** les modules de refroidissement (20) peuvent être raccordés à la conduite d'arrivée et de retour.

10. Ensemble de dispositifs selon la revendication 9, **caractérisé en ce que** la conduite d'arrivée et de retour présente des raccords rapides aptes à être connectés et déconnectés sans gouttes, au moyen desquels les modules de refroidissement (20) sont raccordés.

11. Ensemble de dispositifs selon l'une quelconque des revendications 1 à 10, **caractérisé en ce que** les composants électriques (31) se présentent sous la forme d'unités de serveur, qui présentent des structures de canaux de refroidissement s'étendant dans la direction de la profondeur de l'armoire de distribution, et **en ce que** l'ouverture d'expulsion (13) est associée à la structure de canaux de refroidissement dans la région de la face frontale de l'armoire de distribution (30) et l'entrée d'air (14) y est associée dans la région de la face dorsale de l'armoire de distribution (30).
